# EUROPEAN PATENT APPLICATION

(11) **EP 1 465 256 A1**
(43) Date of publication of application: **06.10.2004**
(21) Application number: 03388021.2
(22) Date of filing: 03.04.2003
(51) Int. Cl.: H01L 25/075

(54) **A method of producing a light source and a light source assembly**

(71) Applicant: Micro Photonics Technology, 2800 Kgs. Lyngby (DK)
(72) Inventor: The designation of the inventor has not yet been filed
(74) Representative: Nielsen, Henrik Sten

(57) **Abstract**

A method of producing a light source by assembling and bonding semiconductor dies or elements such as light emitting diode dies to a substrate comprises providing the substrate, which defines a planar surface and comprises a first plurality of electrically conductive pads. The method further comprises providing a second plurality of the semiconductor elements, each of the semiconductor elements comprising a p-doped part and an n-doped part defining respective opposite, planar contact surfaces having respective electrical conductive bonding areas and placing two semiconductor elements of the second plurality on each of the electrically conductive pads, having alternating p-doped and n-doped parts facing the substrate. Furthermore, the method comprises performing a bonding of the electrical conductive bonding area of the p-doped part and n-doped parts facing the substrate to the pads of the first plurality, and performing a wire bonding using a metallic bonding wire for bonding each pad to a neighbouring pad by wire bonding the electrical conductive bonding area of the p-doped part facing away from the substrate to the n-doped part facing away from the substrate of the neighbouring pad.

## Description

The present invention relates to a light source comprising two or more light emitting diode dies bonded to a substrate.

Light emitting diode based light sources are used for various technical applications such as curing lights for dental purposes, curing lights for the industry, light sources used for cosmetic treatment, light sources used for medical treatment and light sources used for chemical analysis. A light source for curing purposes is required to deliver high intensity light having a specific spectral distribution around a specific wavelength.

The use of a traditional bulb in an apparatus for curing results in a high, unintended, production of excess heat and thus results in a poor utilisation of the energy. The use of light emitting diode technology improves the utilisation of the energy of such devices. Traditionally, light emitting diodes have been individually encapsulated, such a light emitting diode is described in US 4,478,588, an array of light emitting diodes of this type gives a low diode to area ratio as compared to mounting the individual light emitting diode directly to a printed circuit board, such as described in EP 1,090,608.

Topics such as reliability, product lifetime, power consumption and control of spectral distribution are key points that favour light emitting diode solutions over traditional light sources for technical applications such as curing lights for dental clinics, curing lights for the industry, light sources for medical treatment and light sources used for chemical analysis. The spectral distribution of the light emitted by a light source comprising light emitting diodes may by controlled or altered at any given time of operation.

The light emitting diodes has the drawback of being Omni-directionally radiating necessitating the use of one or more reflectors in order to produce a light beam having the intensity needed for curing or chemical analysis or the like, alternatively a number of light emitting diodes dies may be placed in close proximity to form a single light emitting diode based light source, further alternatively, placing the light emitting diode die in a reflector and adding a lens system increases the intensity of the light emitted by the light emitting diode in a specific direction. Enlarging the area of a light emitting diode die increases the intensity of the light emitted by the light emitting diode, however, the heat generated in the light emitting diode die increases with the intensity of the light emitted by the light emitting diode die. Factors such as current through the light emitting diode die and the temperature of the light emitting diode die has an influence on the intensity of the light emitted by the light emitting diode die.

Most assembling techniques known today are based on connecting at least two terminals of a semiconductor die, such as a light emitting diode, to two separate conductive pads of the die. These conductive pads connect to the outside of the die and serve as paths for conducting current through the semiconductor die. The connection from the top side of the semiconductor die to the conductive path is often obtained by wire bonding, wherein a wire made from an electrical conducting material, such as gold or aluminium, the one end of the wire being connected to the one terminal of the semiconductor die and the other end of the wire is connected to the conductive pad, the terminal on the bottom of the semiconductor die is directly bonded to another conductive pad on the chip, the bonding may be achieved by soldering, alternatively scrub bonding, epoxy bonding or eutectic bonding, alternatively by any combination thereof.

The present invention relates to a novel technique that addresses the majority of the issues described above, thereby making it possible to manufacture a light emitting diode based light source emitting light in a concentrated beam in a specific direction having a high intensity, also the present invention is contemplated to improve the durability of the light emitting diode based light source.

The present invention relates to a novel technique of assembling a light emitting diode based light source comprising two or more light emitting diode dies, alternatively each light emitting diode die may be surrounded by a reflector providing optical radiation in a specific direction, further alternatively the entire assembly may be surrounded by a reflector.

The invention further includes a novel technique for placement of semiconductor dies or elements, such as light emitting diode dies, and bonding thereof.

In a light source comprising two or more light emitting diode dies, the light emitting diode dies need not have equal electrical, optical or mechanical characteristics, but the light emitting diode dies need to have at least one contact area which may be used for the bonding of a bonding wire and one contact area for bonding to a conducting pad on the substrate.

According to a first aspect of the present invention, a method is provided of producing a light source by assembling and bonding semiconductor dies or elements such as light emitting diode dies to a substrate, said method comprising:
(i) providing said substrate, said substrate defining a planar surface, said substrate comprising a first plurality of electrically conductive pads,
(ii) providing a second plurality of said semiconductor elements, each of said semiconductor elements comprising a p-doped part and an n-doped part defining respective opposite, planar contact surfaces having respective electrical conductive bonding areas,
(iii) placing two semiconductor elements of said second plurality on each of said electrically conductive pads, having alternating p-doped and n-doped parts facing said substrate,
(iv) performing a bonding of said electrical conductive bonding area of said p-doped part and n-doped parts facing said substrate to said pads of said first plurality, and
(v) performing a wire bonding using a metallic bonding wire for bonding each pad to a neighbouring pad by wire bonding the electrical conductive bonding area of the p-doped part facing away from said substrate to the n-doped part facing away from said substrate of the neighbouring pad.

According to a second aspect of the present invention, a method is provided of producing a light source by assembling and bonding semiconductor dies or elements such as light emitting diode dies to a substrate, said method comprising:
(i) providing said substrate, said substrate defining a planar surface, said substrate comprising a first plurality of electrically conductive pads,
(ii) providing a second plurality of said semiconductor elements, each of said semiconductor elements comprising a p-doped part and an n-doped part defining respective opposite, planar contact surfaces having respective electrical conductive bonding areas, said opposite, planar contact surfaces defining a specific height,
(iii) providing a third plurality of conductive elements, each of said conductive elements defining respective opposite, planar contact surfaces and having a height corresponding to said specific height of said semiconductor elements,
(iv) placing a semiconductor elements of said second plurality on each of said electrically conductive pads, all said semiconductor elements having the same orientation either said p-doped or said n-doped parts facing said substrate, arranging conductor elements of said third plurality on each of said electrically conductive pads having one of its planar contact surfaces facing said substrate,
(v) performing a bonding of said electrical conductive bonding area of said p-doped part or n-doped parts facing said substrate to said pads of said first plurality, performing a bonding of said conductive elements to said pads of said first plurality, and
(vi) performing a wire bonding using a metallic bonding wire for bonding each pad to a neighbouring pad by wire bonding the electrical conductive bonding area of either the p-doped part facing away from said substrate or the n-doped part facing away from said substrate to the planar contact surface of the conductive element of the neighbouring pad facing away from said surface.

According to a third aspect of the present invention, a method is provided of producing a light source by assembling and bonding semiconductor dies or elements such as light emitting diode dies to a substrate, said method comprising:
(i) providing said substrate, said substrate defining a planar surface, said substrate comprising a first plurality of electrically conductive pads,
(ii) providing a second plurality of said semiconductor elements, each of said semiconductor elements comprising a p-doped part and an n-doped part defining respective opposite, planar contact surfaces having respective electrical conductive bonding areas defining a specific height,
(iii) providing a third plurality of conductive elements, each of said conductive elements defining respective opposite, planar contact surfaces and having a height corresponding to said specific height,
(iv) placing a semiconductor elements of said second plurality on each of said electrically conductive pads, said semiconductor elements having alternating orientation either said p-doped or said n-doped parts facing said substrate, placing a conductor element of said third plurality on each of said electrically conductive pads,
(v) performing a bonding of said electrical conductive bonding area of said p-doped part or n-doped parts facing said substrate to said pads of said first plurality, performing a bonding of said conductive element to said pads of said first plurality, and
(vi) performing a wire bonding using a metallic bonding wire for bonding each pad to a neighbouring pad by wire bonding the electrical conductive bonding area of either the p-doped part facing away from said substrate or the n-doped part facing away from said substrate to said electrical conductive bonding area of either the p-doped part or n-doped part of the semiconductor element of the neighbouring pad facing away from said substrate, wire bonding the planar contact surface of the conductive element facing away from said surface to the planar contact surface of the conductive element facing away from said surface of the neighbouring pad.

According to a fourth aspect of the present invention, a method is provided of producing a light source by assembling and bonding semiconductor dies or elements such as light emitting diode dies to a substrate, said method comprising:
(i) providing said substrate, said substrate defining a planar surface, said substrate at least two electrically conductive pads,
(ii) providing a plurality of said semiconductor elements, each of said semiconductor elements having opposite top and bottom surfaces defining a specific height therebetween, each of said semiconductor elements comprising a p-doped part and an n-doped part including electrical conductive bonding areas exposed at said top surface,
(iii) providing at least two conductive elements, each of said conductive elements defining respective opposite, planar contact surfaces and having a height corresponding to said height of said semiconductor elements,
(iv) placing a semiconductor elements of said plurality on said substrate in insulated relationship relative to said substrate and having said top surface facing away from said substrate, arranging a conductor element on each of said electrically conductive pads having one of its planar contact surfaces facing said substrate,
(v) fixating said semiconductor element to said substrate,
(vi) performing a bonding of said conductive elements to said pads, and
(vii) performing a wire bonding using a metallic bonding wire for bonding said conductive elements to two neighbouring semiconductor elements by wire bonding to respective bonding areas of said p-doped and n-doped parts, respectively, of said neighbouring semiconductor elements, and by wire bonding each non-bonded electrical conductive bonding area of the p-doped part of said semiconductor elements to the electrical conductive bonding area of the n-doped part of the neighbouring semiconductor element.

In the present context the term: doped, is considered to be a generic term for the parts of the light emitting diode dies comprising the anode part and cathode part, or plus pole and negative pole. The light emitting diode may comprise multiple layers irrespective of this definition.

In the present context the term: neighbouring, is considered to cover the geometrical relationship of two semiconductor elements or a semiconductor element and a conductor or the geometrical relationship of two conductors, placed in such a way that a electrical connection formed by a wire bonding is obtainable without establishing short-circuit conditions.

According to the basic teachings of the present invention, the semiconductor dies or elements such as the light emitting diode dies are arranged so as to allow the wire bonding to be performed at the top surfaces of the semiconductor dies or elements exclusively, i.e. as the electrical conductive bonding areas facing away from the substrate, thereby facilitating the wire bonding technique which is performed at the level of the top surfaces of the semiconductor dies or elements. According to the alternatives of the method of the present invention as defined in the second, third and fourth aspect of the present invention as defined above, the single level wire bonding technique also allows the use of conductive elements in combination with the semiconductor elements for facilitating and improving the wire bonding.

According to the method as defined above according to the first, second, third and fourth aspect of the present invention, the substrate used according to the teachings of the present invention may be constituted by a heat conductive material such as a ceramic material, e.g. aluminium oxide or beryllium oxide or a metallic material, alternatively a combination of a ceramic and metallic material and or a polymer sheet in combination with a ceramic and/or a metallic foil, e.g. as a combination of a thin non-conductive polymer sheet and a metallic or ceramic foil.

For allowing a high intensity light source to be produced allowing the heat generated in the semiconductor elements or dies to be transported away from the light source assembly. The substrate may itself or in a combination with a separate element provide a heat sink for conducting the heat from the individual semiconductor dies or elements. The bonding of the semiconductor elements and/or the conductive elements to the substrate may be performed by epoxy bonding, by eutectic bonding, by scrub bonding or by soldering or further alternatively in a combination process involving the above techniques.

The bond wire used for the wire bonding according to the method according to the three aspects of the present invention as defined above may be constituted by a metallically conductive material such as gold or aluminium or another electrically conductive metallic material in combination with a support polymer thread or foil or alternatively a combination thereof.

For facilitating the process of placing the semiconductor elements and/or the combination of semiconductor elements and conductive elements on the substrate, a supporting plate having apertures may be used for holding the semiconductor elements in the apertures by the use of vacuum suction. The supporting plate may be used for fixating the semiconductor elements or dies relative to the substrate during the bonding step and may according to two alternatives comprised by the present invention be kept in place after the bonding has taken place serving as a mechanical support and or a thermal conductor. Alternatively, the supporting plate is removed after the completion of the bonding of the semiconductor elements or dies and/or the conductive elements to the substrate before the wire bonding step be performed. The plate itself may for the above-described first application be provided with a light reflecting coating such as a nickel or chrome coating allowing the supporting plate to be used as a reflector or light guide, alternatively, the coating may be made of another material having specific light reflecting properties at the wave length of the light emitted by the semiconductor elements or light emitting diode dies.

The present invention further relates to a light source assembly including light emitting diode dies and produced in accordance with the above-described four aspects of the present invention. In greater details, the present invention relates, in a fifth aspect, to a light source assembly including light emitting diode dies, said assembly comprising:
(i) a substrate, said substrate defining a planar surface, said substrate comprising a first plurality of electrically conductive pads,
(ii) a second plurality of semiconductor elements, each of said semiconductor elements comprising a p-doped part and an n-doped part defining respective opposite, planar contact surfaces having respective electrical conductive bonding areas,
(iii) each of said electrically conductive pads including two semiconductor elements of said second plurality, having alternating p-doped and n-doped parts facing said substrate,
(iv) a bonding of said electrical conductive bonding area of said p-doped part and n-doped parts facing said substrate to said pads of said first plurality being bonded to said pads, and
(v) a wire bonding by providing a metallic bonding wire, bonding each pad to a neighbouring pad by wire bonding the electrical conductive bonding area of the p-doped part facing away from said substrate to the n-doped part facing away from said substrate of the neighbouring pad.

In a sixth aspect the present invention relates to a light source assembly including light emitting diode dies, said assembly comprising:
(i) a substrate, said substrate defining a planar surface, said substrate comprising a first plurality of electrically conductive pads,
(ii) a second plurality of semiconductor elements, each of said semiconductor elements comprising a p-doped part and an n-doped part defining respective opposite, planar contact surfaces having respective electrical conductive bonding areas, said opposite, planar contact surfaces defining a specific height,
(iii) a third plurality of conductive elements, each of said conductive elements defining respective opposite, planar contact surfaces and having a height corresponding to said height of said semiconductor elements,
(iv) each of said electrically conductive pads including a semiconductor elements of said second plurality, all said semiconductor elements having the same orientation either said p-doped or said n-doped parts facing said substrate, said conductor elements of said third plurality arranged on each of said electrically conductive pads having one of its planar contact surfaces facing said substrate,
(v) a bonding of said electrical conductive bonding area of said p-doped part or n-doped parts facing said substrate to said pads of said first plurality, a bonding of said conductive elements to said pads of said first plurality, and
(vi) a wire bonding by providing a metallic bonding wire, bonding each pad to a neighbouring pad by wire bonding the electrical conductive bonding area of either the p-doped part facing away from said substrate or the n-doped part facing away from said substrate to the planar contact surface of the conductive element of the neighbouring pad facing away from said surface.

In a seventh aspect the present invention relates to a light source assembly including light emitting diode dies, said assembly comprising:
(i) a substrate, said substrate defining a planar surface, said substrate comprising a first plurality of electrically conductive pads,
(ii) a second plurality of semiconductor elements, each of said semiconductor elements comprising a p-doped part and an n-doped part defining respective opposite, planar contact surfaces having respective electrical conductive bonding areas, said opposite, planar contact surfaces defining a specific height,
(iii) a third plurality of conductive elements, each of said conductive elements defining respective opposite, planar contact surfaces and having a height corresponding to said height of said semiconductor elements,
(iv) on each of said electrically conductive pads including a semiconductor element of said second plurality, said semiconductor elements having alternating orientation either said p-doped or said n-doped parts facing said substrate and a conductor element of said third plurality,
(v) a bonding of said electrical conductive bonding area of said p-doped part or n-doped parts facing said substrate to said pads of said first plurality, a bonding of said conductive elements to said pads of said first plurality, and
(vi) a wire bonding by providing a metallic bonding wire bonding each pad to a neighbouring pad by wire bonding the electrical conductive bonding area of either the p-doped part facing away from said substrate or the n-doped part facing away from said substrate to said electrical conductive bonding area of either the p-doped part or n-doped part of the semiconductor element of the neighbouring pad facing away from said substrate, wire bonding the planar contact surface of the conductive element facing away from said surface to the planar contact surface of the conductive element facing away from said surface of the neighbouring pad.

In a light source assembled according to the present invention the light emitting diode dies in the light source assembly may be electrically arranged in multiple branches of serial connected dies. As an example in a light emitting diode light source comprising 48 light emitting diode dies, the light emitting diode dies may be arranged in 6 branches of 8 light emitting diode dies, the individual branches may be electrically turned on or off independent of the other branches, alternatively the current through the branches may be varied individually, other configuration are obviously also possible, such as 3 branches of 16 light emitting diode dies, alternatively 12 branches of 4 light emitting diode dies. Further alternatively the branches may comprise unequal numbers of light emitting diode dies.

As mentioned above the light emitting diode light source may be fitted with a lens system for further directing the light emitted from the light emitting diode light source in a specific direction, the lens system may be of a material such as epoxy alternatively the material may be glass or further alternatively silicone. The lens system may be moulded in one piece alternatively the lens system may be moulded in multiple successive processes forming a multi-lens system.

The method according to the present invention is explained in the following with references to the drawings in which
In Fig. 1, a side view of a light source comprising light emitting diodes bonded using a traditional bonding method is illustrated,
in Fig. 2, a side view of a light source comprising light emitting diodes bonded using the bonding method according to the present invention is illustrated,
in Fig. 3, a side view of a light source comprising light emitting diodes bonded using the bonding method according to the present invention is illustrated, the light source further comprising conductive elements,
in Fig. 4, a side view of a light source comprising light emitting diodes bonded using the bonding method according to the present invention is illustrated, the light source further comprising conductive elements,
in Fig. 5, a side view of a light source comprising light emitting diodes bonded using the bonding method according to the present invention is illustrated, the light source further comprising conductive elements, the light emitting diode dies having electrical conductive bonding areas on the top surface,
in Fig. 6, a top view of a light source comprising light emitting diode dies bonded using the bonding method according to the present invention is illustrated,
in Fig. 7, a bottom view of a light source comprising light emitting diode dies bonded using the bonding method according to the present invention, the light source having multiple electrical serial connections, is illustrated, and
in Fig. 8, a side cross sectional view of a light source comprising light emitting diode dies bonded according to the present invention and having a lens system, reflector system and a heat sink is illustrated.

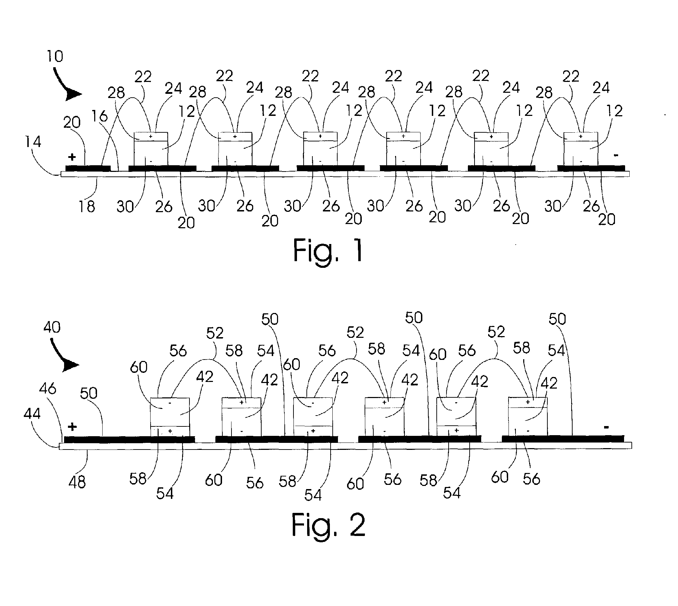

In Fig. 1, a schematic side view of a light source is shown. The light source is designated the reference numeral 10. The light source 10 comprises light emitting diodes 12, having a top side 24 and a bottom side 26, further having a plus-pole 28 and a negative-pole 30 at the top side 24 and the bottom side 26, respectively. The light source 10 further comprises a substrate material 14 having a top surface 16 and an opposite bottom surface 18, the substrate 14 further comprises conductive pads 20 on the top surface 16. The bonding is performed by bonding one end of a metallic bonding wire 22 to the top side 24 of the light emitting diode die 12 and the other end to a electrical conductive pad 20 on the substrate 14, thus the bonding is performed in two physical planes or at two different levels, the total number of metallic bonding wires 22 used to bond six light emitting diodes 12 is six.

It has been realised that reliable wire bonding in a complex multi-die assembly is a complicated process to perform and multi-die assemblies having a high number of wire bonds tend to have low reliability, low production yield and a high production cost. In order to perform the wire bonding from the semiconductor die to the substrate, a clearing distance from the substrate bonding area to the die is mandatory in order to have room for the bonding tool to access the bond area on the substrate.

In Fig. 2, a schematic side view similar to the view of fig 1 is illustrated of a light source 40 comprising six light emitting diodes 42. Each light emitting diode die 42 having a first side 54 and a second side 56, further having a positive-pole 58 and a negative-pole 60, respectively, the light emitting diodes 42 are bonded using the bonding method according to the teachings of the present invention. The light source 40 further comprises a substrate material 44 having a top surface 46 and a bottom surface 48. The substrate 44 further comprises electrically conductive pads 50 on the top surface 46. The light emitting diode dies 42 are positioned on the substrate 44 having alternating plus poles 58 and negative poles 60 facing the top surface 46 of the substrate 44. The bonding is performed from the first side 54 of one light emitting diode die 42 to the neighbouring light emitting diode die 42, thus the bonding is performed in one physical plane or level.

A further advantage of the present invention is obvious from the illustration in Fig. 2 namely a reduced number of bonding wires 52 used for performing the bonding. In a light source 40 comprising six light emitting diode dies 42 the number of bondings performed using the method according to the present invention is three as opposed to six bondings performed using the traditional bonding technique.

The substrate 44 may be based on ceramics or alternatively on metal or further alternatively the base may comprise a non-conducting material, such as a polymer sheet, and a material for thermal conductance. The use of a thin polymer sheet having a horizontal plane during the placement of the individual light emitting diode dies 42 may be used to form the assembly to be connected into a non-horizontal plane of the substrate in the final light emitting diode based light source 40.

The bottom bonding is forming the bonding between the light emitting diode dies 42 and the substrate 44, the bonding provides a mechanical adhesion as well as an electrical and thermal path from the light emitting diode dies 42 to the substrate 44. The bonding may be achieved by using a conducting epoxy, alternatively solder, alternatively scrub bonding or euthectic bonding.

For utilising the light emitted by each of the light emitting dies, the material or the layer of the individual light emitting diode dies facing away from the supporting substrate 44 needs to be made from a light transparent or at least transparent to the wave lengths or the wave length area admitted by the die in question.

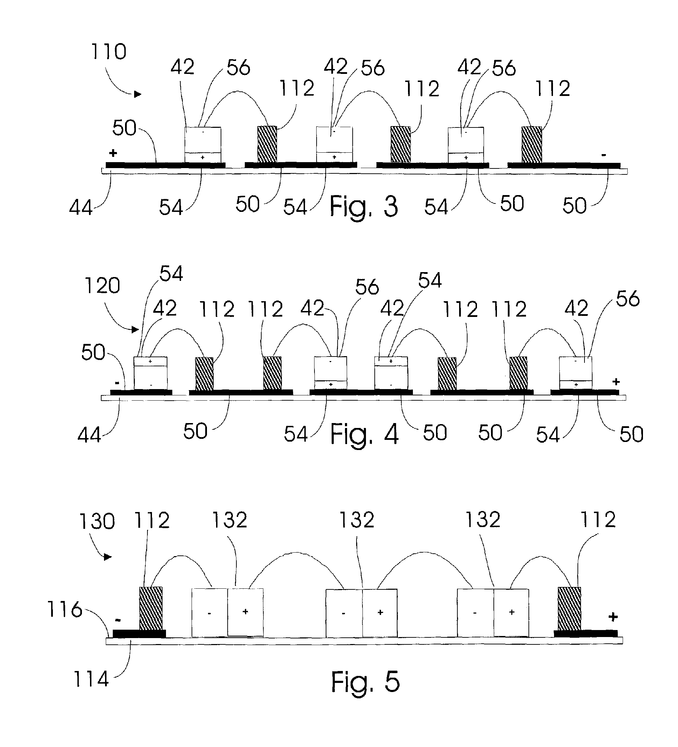

In Fig. 3, a schematic side view of a light source 110 is illustrated. The light source 110 comprises three light emitting diode dies 42 and three conductor elements 112. On each of the electrically conductive pads one light emitting diode die 42 and one conductive element 112 is arranged. The light emitting diode dies 42 are all arranged such that they all have either the p-doped or the n-doped part facing the substrate.

In Fig. 4, a schematic side view of a light source 120 is illustrated. The light source 120 comprises four light emitting diode dies 42 and four conductor elements 112. The light source comprises a substrate 44, the substrate comprises electrical pads 50. On each of the electrically conductive pads 50 either two light emitting diode dies 42 or two conductive elements 112 is arranged. The bonding is performed from either a conductive element 112 to a light emitting diode die 42, or vice versa. The light emitting diode dies 42 are arranged such that the two light emitting diode dies 42 of each pad have alternating orientation of the respective first sides 54 relative to the substrate 44.

In Fig. 5, a schematic side view of a light source 130 is illustrated. The light source 130 comprises three light emitting diode dies 132 and two conductor elements 112. The light emitting diode dies 132 having two electrical conductive bonding areas on the top surface of the die, consequently there is no need for bonding the light emitting diode die 132 to an electrical conductive pad on the top surface 116 of the substrate 114. The bonding, or fixation, of the light emitting diode die 132 to the substrate 114 may be performed by applying an adhesive, such as epoxy, alternatively the fixation may be obtained by heat welding.

The views of Figs. 2-5 illustrate vertical sectional views of a set of diode dies 42 and a supporting substrate 44. It is to be realised that the technique of providing wire bonding from one die to a neighbouring die or in the alternative to a conductive element may be used for the entire assembly providing a single structure made from identical or different dies provide the same. Provided the light emitting dies are of identical structure, each and every die emit the same light or light being visible light, IR or UV light of the same wavelength or the same wavelength area or substantially of the same spectral distribution. Provided different light emitting dies be used, the individual light emitting die having a specific spectral distribution emits light being visible light, or IR or UV of the light distribution in question, whereas the other dies emit light of the light distribution of the die in question. In the alternative or further embodiment of the light source, different light emitting sections or branches are provided according to the teachings of the present invention, as one branch or one section may include a specific number of light emitting diodes and emit a light of specific wavelength distribution, whereas a different section or a different branch provided in accordance with the teachings of the present invention or in the alternative produced in accordance with an alternative technique, such as a technique illustrated in Fig. 1 may emit light of a different spectral distribution. Provided a structure or light source be produced having two or more branches, the one branch may be controlled for emitting the light of the specific spectral light distribution of the light emitting diode dies in question for a certain period of time, whereas a different branch be activated for a different period of time allowing the light source to be used in a process for controlling or a reaction by the emission of two alternative or two or more alternative spectral distributions for different periods of time.

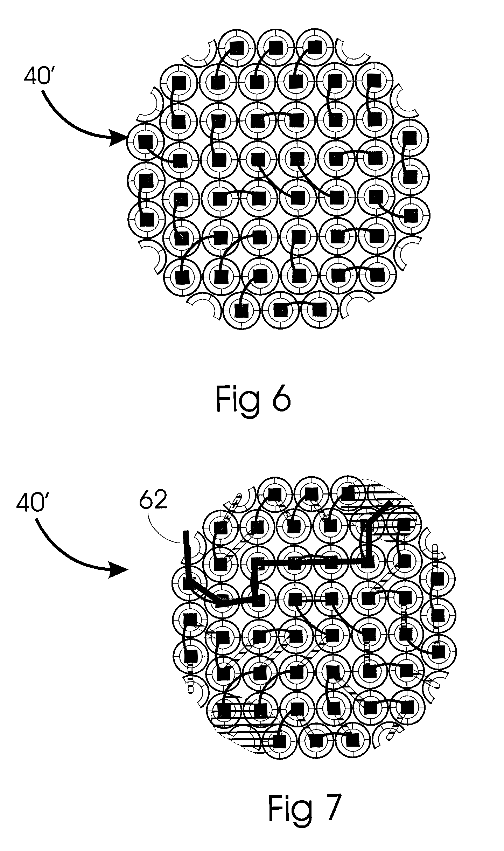

In Fig. 6 a top view of the light source 40 of fig 2 is illustrated. The light emitting diode dies 42 are bonded using the bonding method according to the present invention.

In Fig. 7 a bottom view of the light source 40 of fig. 2 is illustrated. The figure illustrates the light source further having multiple branches of electrical serial connections, such as show by the line 62. The individual branches may be electrically turned on or off independent of the other branches, alternatively the current through the branches may be varied individually.

The overall geometrical configuration of the arrangement of the light emitting diodes 42 may, as depicted in fig. 3 and fig. 4, be circular, alternatively the light emitting diode dies may be arranged in a oval, square or oblong configuration, or any other geometrical configuration.

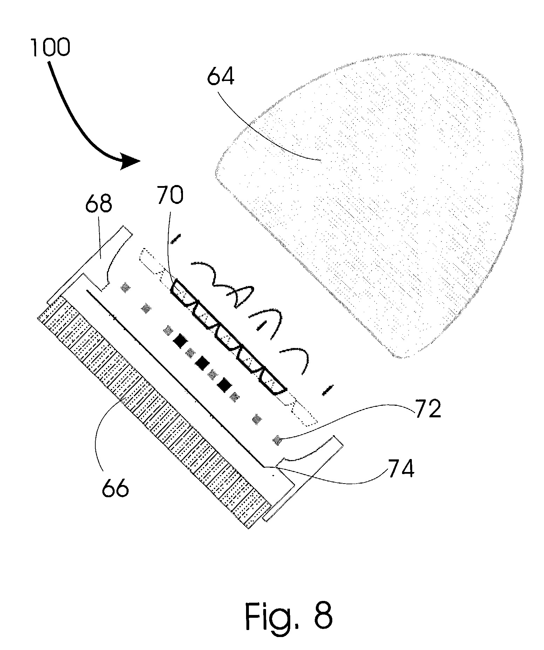

In Fig. 8, a side cross sectional view of a light source 100 comprising light emitting diode dies 72 bonded to a substrate 74 according to the present invention is illustrated. The light source 100 further comprising a heat sink 66. Around the individual light emitting diode dies 72 is mounted optical reflectors 70, around the entire assembly is mounted a large optical reflector 68. The assembly is fitted with a lens system 64.

It is to be understood that the present invention is by no means limited to the above described presently preferred embodiment of the technique according to the present invention, as numerous modifications and alterations are obvious to a person having ordinary skill in the art and such modifications and alterations are to be considered part of the invention as defined in the appending claims. In particular, the technique of bonding the light emitting diodes together or to conductive elements by means of wire bonds, may be modified by substituting the metallic bonding wires may be substituted by e.g. a solid or a flexible PCB or substrate including conductor or wire elements serving the purpose of establishing electrical conductive connection between the light emitting diode dies and/or the light emitting diode dies and conductive elements. In particular, the steps of establishing the wire bonding may be substituted with alternative equivalent techniques such as the above described technique of establishing electrical conductive connection by means of a flexible or solid PCB or a substrate.

## Claims

1. A method of producing a light source by assembling and bonding semiconductor dies or elements such as light emitting diode dies to a substrate, said method comprising:
(i) providing said substrate, said substrate defining a planar surface, said substrate comprising a first plurality of electrically conductive pads,
(ii) providing a second plurality of said semiconductor elements, each of said semiconductor elements comprising a p-doped part and an n-doped part defining respective opposite, planar contact surfaces having respective electrical conductive bonding areas,
(iii) placing two semiconductor elements of said second plurality on each of said electrically conductive pads, having alternating p-doped and n-doped parts facing said substrate,
(iv) performing a bonding of said electrical conductive bonding area of said p-doped part and n-doped parts facing said substrate to said pads of said first plurality, and
(v) performing a wire bonding using a metallic bonding wire for bonding each pad to a neighbouring pad by wire bonding the electrical conductive bonding area of the p-doped part facing away from said substrate to the n-doped part facing away from said substrate of the neighbouring pad.

2. A method of producing a light source by assembling and bonding semiconductor dies or elements such as light emitting diode dies to a substrate, said method comprising:
(i) providing said substrate, said substrate defining a planar surface, said substrate comprising a first plurality of electrically conductive pads,
(ii) providing a second plurality of said semiconductor elements, each of said semiconductor elements comprising a p-doped part and an n-doped part defining respective opposite, planar contact surfaces having respective electrical conductive bonding areas, said opposite, planar contact surfaces defining a specific height,
(iii) providing a third plurality of conductive elements, each of said conductive elements defining respective opposite, planar contact surfaces and having a height corresponding to said specific height of said semiconductor elements,
(iv) placing a semiconductor elements of said second plurality on each of said electrically conductive pads, all said semiconductor elements having the same orientation either said p-doped or said n-doped parts facing said substrate, arranging a conductor element of said third plurality on each of said electrically conductive pads having one of its planar contact surfaces facing said substrate,
(v) performing a bonding of said electrical conductive bonding area of said p-doped part or n-doped parts facing said substrate to said pads of said first plurality, performing a bonding of said conductive elements to said pads of said first plurality, and
(vi) performing a wire bonding using a metallic bonding wire for bonding each pad to a neighbouring pad by wire bonding the electrical conductive bonding area of either the p-doped part facing away from said substrate or the n-doped part facing away from said substrate to the planar contact surface of the conductive element of the neighbouring pad facing away from said surface.

3. A method of producing a light source by assembling and bonding semiconductor dies or elements such as light emitting diode dies to a substrate, said method comprising:
(i) providing said substrate, said substrate defining a planar surface, said substrate comprising a first plurality of electrically conductive pads,
(ii) providing a second plurality of said semiconductor elements, each of said semiconductor elements comprising a p-doped part and an n-doped part defining respective opposite, planar contact surfaces having respective electrical conductive bonding areas, defining a specific height,
(iii) providing a third plurality of conductive elements, each of said conductive elements defining respective opposite, planar contact surfaces and having a height corresponding to said specific height,
(iv) placing a semiconductor elements of said second plurality on each of said electrically conductive pads, said semiconductor elements having alternating orientation either said p-doped or said n-doped parts facing said substrate, placing a conductor element of said third plurality on each of said electrically conductive pads,
(v) performing a bonding of said electrical conductive bonding area of said p-doped part or n-doped parts facing said substrate to said pads of said first plurality, performing a bonding of said conductive element to said pads of said first plurality, and
(vi) performing a wire bonding using a metallic bonding wire for bonding each pad to a neighbouring pad by wire bonding the electrical conductive bonding area of either the p-doped part facing away from said substrate or the n-doped part facing away from said substrate to said electrical conductive bonding area of either the p-doped part or n-doped part of the semiconductor element of the neighbouring pad facing away from said substrate, wire bonding the planar contact surface of the conductive element facing away from said surface to the planar contact surface of the conductive element facing away from said surface of the neighbouring pad.

4. A method of producing a light source by assembling and bonding semiconductor dies or elements such as light emitting diode dies to a substrate, said method comprising:
(i) providing said substrate, said substrate defining a planar surface, said substrate at least two electrically conductive pads,
(ii) providing a plurality of said semiconductor elements, each of said semiconductor elements having opposite top and bottom surfaces defining a specific height therebetween, each of said semiconductor elements comprising a p-doped part and an n-doped part including electrical conductive bonding areas exposed at said top surface,
(iii) providing at least two conductive elements, each of said conductive elements defining respective opposite, planar contact surfaces and having a height corresponding to said height of said semiconductor elements,
(iv) placing a semiconductor elements of said plurality on said substrate in insulated relationship relative to said substrate and having said top surface facing away from said substrate, arranging a conductor element on each of said electrically conductive pads having one of its planar contact surfaces facing said substrate,
(v) fixating said semiconductor element to said substrate,
(vi) performing a bonding of said conductive elements to said pads, and
(vii) performing a wire bonding using a metallic bonding wire for bonding said conductive elements to two neighbouring semiconductor elements by wire bonding to respective bonding areas of said p-doped and n-doped parts, respectively, of said neighbouring semiconductor elements, and by wire bonding each non-bonded electrical conductive bonding area of the p-doped part of said semiconductor elements to the electrical conductive bonding area of the n-doped part of the neighbouring semiconductor element.

5. The method according to claim 4, wherein said fixation is performed by means of an adhesive or by welding.

6. The method according to any of the claims 1-5,
wherein:
said substrate being a heat conductive material, such as a ceramics material or a metallic material, alternatively said substrate being a thin non-conducting material, such as a polymer sheet.

7. The method according to any of the claims 1-6,
said method further comprising:
providing a heat-sink base defining a planar heat-sink surface, said substrate defining a bottom surface opposite said planar surface, said planar heat-sink surface mounted on said bottom surface of said substrate.

8. The method according to any of the claims 1-7,
wherein:
said step (iv) of claim 1, said step (v) of claim 2 and/or said step (v) of claim 3 being formed by a eutectic bonding, by epoxy bonding, by scrub bonding or by soldering, alternatively by a combination thereof.

9. The method according to any of the claims 1-8,
wherein:
said bond wire being of a electrically conducting material such as gold or aluminium or another electrically conducting metallic material, alternatively a combination thereof.

10. The method according to any of the claims 1-3,
said method further comprising the intermediate steps of claim 1 between step (ii) and step (iii), or claim 2, 3 or 4 between step (iii) and step (iv):
(i) providing a plate having apertures, holding said semiconductor elements in said apertures using a vacuum suction,
(ii) placing said semiconductor elements on said top surface of said substrate using said plate.

11. The method according to claim 10,
wherein:
said plate having a light reflecting coating, said coating being of a material such as Nickel, alternatively Chrome, further alternatively another material having light reflecting properties at the wavelength of the light emitted by said semiconductor elements or alternatively a combination thereof.

12. The method according to any of the claims 10 or 11,
said method further comprising the intermediate step of claim 1 between step (ii) and step (iii), or claim 2, 3 or 4 between step (iii) and step (iv):
(i) removing said plate before performing step (iv) of claim 1, step (vi) of claim 2, step (vi) of claim 3 and/or step (vi) of claim 4.

13. A light source assembly including light emitting diode dies, said assembly comprising:
(i) a substrate, said substrate defining a planar surface, said substrate comprising a first plurality of electrically conductive pads,
(ii) a second plurality of semiconductor elements, each of said semiconductor elements comprising a p-doped part and an n-doped part defining respective opposite, planar contact surfaces having respective electrical conductive bonding areas,
(iii) each of said electrically conductive pads including two semiconductor elements of said second plurality, having alternating p-doped and n-doped parts facing said substrate,
(iv) a bonding of said electrical conductive bonding area of said p-doped part and n-doped parts facing said substrate to said pads of said first plurality being bonded to said pads, and
(v) a wire bonding by providing a metallic bonding wire, bonding each pad to a neighbouring pad by wire bonding the electrical conductive bonding area of the p-doped part facing away from said substrate to the n-doped part facing away from said substrate of the neighbouring pad.

14. A light source assembly including light emitting diode dies, said assembly comprising:
(i) a substrate, said substrate defining a planar surface, said substrate comprising a first plurality of electrically conductive pads,
(ii) a second plurality of semiconductor elements, each of said semiconductor elements comprising a p-doped part and an n-doped part defining respective opposite, planar contact surfaces having respective electrical conductive bonding areas, said opposite, planar contact surfaces defining a specific height,
(iii) a third plurality of conductive elements, each of said conductive elements defining respective opposite, planar contact surfaces and having a height corresponding to said height of said semiconductor elements,
(iv) each of said electrically conductive pads including a semiconductor elements of said second plurality, all said semiconductor elements having the same orientation either said p-doped or said n-doped parts facing said substrate, said conductor elements of said third plurality arranged on each of said electrically conductive pads having one of its planar contact surfaces facing said substrate,
(v) a bonding of said electrical conductive bonding area of said p-doped part or n-doped parts facing said substrate to said pads of said first plurality, a bonding of said conductive elements to said pads of said first plurality, and
(vi) a wire bonding by providing a metallic bonding wire, bonding each pad to a neighbouring pad by wire bonding the electrical conductive bonding area of either the p-doped part facing away from said substrate or the n-doped part facing away from said substrate to the planar contact surface of the conductive element of the neighbouring pad facing away from said surface.

15. A light source assembly including light emitting diode dies, said assembly comprising:
(i) a substrate, said substrate defining a planar surface, said substrate comprising a first plurality of electrically conductive pads,
(ii) a second plurality of semiconductor elements, each of said semiconductor elements comprising a p-doped part and an n-doped part defining respective opposite, planar contact surfaces having respective electrical conductive bonding areas, said opposite, planar contact surfaces defining a specific height,
(iii) a third plurality of conductive elements, each of said conductive elements defining respective opposite, planar contact surfaces and having a height corresponding to said height of said semiconductor elements,
(iv) on each of said electrically conductive pads including a semiconductor element of said second plurality, said semiconductor elements having alternating orientation either said p-doped or said n-doped parts facing said substrate and a conductor element of said third plurality,
(v) a bonding of said electrical conductive bonding area of said p-doped part or n-doped parts facing said substrate to said pads of said first plurality, a bonding of said conductive elements to said pads of said first plurality, and
(vi) a wire bonding by providing a metallic bonding wire bonding each pad to a neighbouring pad by wire bonding the electrical conductive bonding area of either the p-doped part facing away from said substrate or the n-doped part facing away from said substrate to said electrical conductive bonding area of either the p-doped part or n-doped part of the semiconductor element of the neighbouring pad facing away from said substrate, wire bonding the planar contact surface of the conductive element facing away from said surface to the planar contact surface of the conductive element facing away from said surface of the neighbouring pad.

16. A light source assembly including light emitting diode dies,
said assembly comprising:
(i) a substrate, said substrate defining a planar surface, said substrate at least two electrically conductive pads,
(ii) a plurality of said semiconductor elements, each of said semiconductor elements having opposite top and bottom surfaces defining a specific height therebetween, each of said semiconductor elements comprising a p-doped part and an n-doped part including electrical conductive bonding areas exposed at said top surface,
(iii) at least two conductive elements, each of said conductive elements defining respective opposite, planar contact surfaces and having a height corresponding to said height of said semiconductor elements,
(iv) a semiconductor elements of said plurality placed on said substrate in insulated relationship relative to said substrate and having said top surface facing away from said substrate, a conductor element arranged on each of said electrically conductive pads having one of its planar contact surfaces facing said substrate,
(v) said semiconductor element fixated to said substrate,
(vi) said conductive elements bonded to said pads, and
(vii) said conductive elements wire bonded to two neighbouring semiconductor elements by wire bonding to respective bonding areas of said p-doped and n-doped parts, respectively, of said neighbouring semiconductor elements, and by wire bonding each non-bonded electrical conductive bonding area of the p-doped part of said semiconductor elements to the electrical conductive bonding area of the n-doped part of the neighbouring semiconductor element.
